# EUROPEAN PATENT SPECIFICATION

(11) **EP 1 118 474 B1**
(45) Date of publication and mention of the grant of the patent: **03.12.2003**
(21) Application number: 00204093.9
(22) Date of filing: 21.11.2000
(51) Int. Cl.: B41N 3/06, B41C 1/10

(54) **METHOD FOR RECYCLING LITHOGRAPHIC PRINTING PLATES.**
VERFAHREN ZUM WIEDERVERWERTEN VON FLACHDRUCKPLATTEN.
PROCEDE DE RECYCLAGE DE PLAQUES D'IMPRESSION LITHOGRAPHIQUES.

(30) Priority: 18.09.2000 EP 00203224; 18.01.2000 EP 00200177
(43) Date of publication of application: 25.07.2001
(73) Proprietor: AGFA-GEVAERT, 2640 Mortsel (BE)
(72) Inventor: Verschueren, Eric, c/o Agfa-Gevaert N.V., 2640 Mortsel (BE); Mertens, Patrick, c/o Agfa-Gevaert N.V., 2640 Mortsel (BE)

(56) References cited:
- EP-A- 0 139 545
- EP-A- 0 174 711
- EP-A- 0 354 027
- US-A- 4 829 897
- US-A- 5 156 760
- US-A- 5 529 723

## Description

### FIELD OF THE INVENTION

The present invention relates to a method for recycling the lithographic substrate of a printing master.

### BACKGROUND OF THE INVENTION

In conventional lithographic printing, ink and an aqueous fountain solution are supplied to the surface of a printing master that contains ink accepting (oleophilic) and water-accepting (hydrophilic) areas. The inked image pattern is then transferred from the surface of the master to a blanket cylinder having a compressible surface. From the blanket cylinder the image is impressed onto paper. The master is typically a printing plate that carries an image on a dimensionally stable substrate such as an aluminium sheet. The imaged aluminium plate is secured to the plate cylinder of a printing press by a mechanical lock-up mechanism that defines positional registration between the plate and the surface of the cylinder. After the end of the press run, the mechanical lock-up system is released so that the printing plate carrying the printed image can be removed and discarded and another printing plate can be positioned and locked into place. A new print job can then be started.

Printing masters are generally obtained by the so-called computer-to-film method wherein each colour selection is transferred to graphic arts film using an image-setter. After processing, the film can be used as a mask for the exposure of an imaging material called plate precursor and after plate processing, a printing plate is obtained which can be used as a master. These steps are usually performed in dedicated exposure and processing equipment and the printing plates are then transported to the printing press and attached to the printing cylinder by press operators using a lock-up mechanism built into the cylinder itself. Although the attachment of the printing cylinder is generally a manual operation, robotic means have been developed for positioning and securing the printing plates.

In recent years the so-called computer-to-plate method has gained a lot of interest. This method, also called direct-to-plate method, bypasses the creation of film because the digital data are transferred directly to a plate precursor by means of a so-called plate-setter. On-press imaging is a direct-to-plate method (also called direct-to-press), wherein the image is exposed on the plate while said plate is mounted on the plate cylinder of a printing press. The major advantage of the latter method compared to off-press plate making is the improved registration between printing stations of a multi-colour printing press.

Two types of such on-press imaging methods are known. According to a first type, a printing plate precursor is mounted on a printing press, image-wise exposed, optionally developed, and then used as a printing master and finally removed from the press and disposed of, thus requiring a new plate material for each image. An example of this technology is the Heidelberg Model GTO-DI, manufactured by Heidelberg Druckmaschinen AG (Germany) which is described in detail in US 5,339,737. A drawback of this method is the need to use a new plate for each press run, thus increasing the cost of the printing process.

In a second type of on-press imaging systems, the same lithographic substrate is used in a plurality of press runs (hereinafter called printing cycles). In each printing cycle, a heat-sensitive or photosensitive layer is coated on the lithographic substrate to make a printing plate precursor and after image-wise exposure and optional development a printing master is obtained. After the press-run, the ink-accepting areas of the printing master are removed from the lithographic substrate in a cleaning step so that the substrate is recycled and can be used in a next cycle of coating, exposing and printing without the need to mount a new plate on the cylinder. Examples of such on-press coating and on-press imaging systems are described in e.g. US 5,188,033; US 5,713,287; EP-A 786 337 and EP-A 802 457. The latter patent application describes an apparatus comprising a printing member, means for applying a uniform coating, means for scan-wise exposing said uniform coating in accordance with an image pattern and means for developing said uniform coating to leave an image on said printing member, the image consisting of ink-accepting areas on an ink-repellent background or ink-repellent areas on an ink-accepting background. According to a preferred embodiment, the coating comprises hydrophobic thermoplastic polymer particles in a hydrophilic binder.

Cleaning liquids for lithographic printing plates have been described in **EP-A-1 118 470, EP-A-1 118 474** and **EP-A-1 118 472** all filed on 18-01-2000 and **DE-A-42 16 636**.

The known cleaning liquids typically contain solvents which are harmful to hoses, pumps and sealings and/or require a very thorough rinsing with water because these liquids are not compatible with the coating step in the next printing cycle.

In the known on-press coating methods, the cleaning of the lithographic substrate often fails because no suitable compromise can be found between the chemical reactivity of the cleaning liquid versus the ink-accepting areas which have to be removed on the one hand and the required inertness of said cleaning liquid versus the fragile lithographic surface on the other hand. A typical lithographic surface is mechanically as well as chemically quite vulnerable. A lithographic surface consists generally of a micro-pore structure in order to obtain a good differentiation between the spreading properties of the ink and the fountain. Anodised aluminium plates comprise a lithographic surface containing one or more metal oxides on which absorption phenomena can take place. These metal oxides are very susceptible to chemical conversion into forms that are no longer lithographically active.

The above mentioned micro-porosity of a lithographic surface is also highly susceptible to mechanical damage. The presence of solid particles in cleaning liquids, which is often required for efficient mechanical cleaning of the lithographic surface, results inevitably in a disturbance of the micro-structure of said surface. Because ink and the coated imaging layer penetrate in the micro-pore structure, it is necessary to carry out a vigorous cleaning so as to avoid ghost images in the subsequent printing cycles, which are due to an incomplete removal of the previous image.

**US-P 4 829 897** describes an automatic blanket wash system for offset printing wherein the washing medium is a water-in-oil emulsion containing water, hydrocarbons and a surfactant. **EP-A 174 711** describes a shelf-stable emulsion for removing ink from printing press component parts comprising d-limonene, water, a surfactant and a stabilizer. **US-P 5 156 760** further describes a cleansing composition for the removal of ink from blanket rollers and cylinders of printing presses comprising terpene alcohol, water and a non-ionic surfactant. In **EP-A 354 027** a solvent composition is described that can be used for the removal of inks from printing presses, comprising a mixture of para-menthadienes, terpene alcohol and optionally other terpene hydrocarbons.

### SUMMARY OF THE INVENTION

It is an object of the present invention to provide a method for removing ink-accepting areas of'a lithographic printing master using a stable micro-emulsion as cleaning liquid which has a low organic volatile content to avoid environmental contamination and which does not attack the hardware of the printing press. The above object is realised by the method of claim 1. The micro-emulsion defined in claim 1 effectively removes the ink-accepting areas of the printing master. No ghost images are observed after several (>10) print cycles of coating, exposure, printing and cleaning. Rubber hoses and seals are not affected by the cleaning liquid.

Further objects of the present invention will become clear from the description hereinafter.

Preferred embodiments of the method of the present invention are defined in the dependent claims.

### DETAILED DESCRIPTION OF THE INVENTION

With the term micro-emulsion as used herein an emulsion having a particle size of less than 1µm and preferably less than 200nm is defined.

The micro-emulsion used in the method according to the present invention is obtained by stirring a mixture of a cyclic organic compound containing at least one double bond, an alcohol, water and an emulsifying agent. Preferably, the micro-emulsion is prepared by first mixing a cyclic organic compound having at least one double bond and an emulsifying agent and then adding alcohol, water and stirring

The obtained micro-emulsion.is very stable in a temperature range of 0°C to 50°C. Suitable examples of cyclic organic compounds having at least one double bond are: toluene, xylene, propylbenzene, 3-methyl-6-isopropyl-1,4-cyclo-hexadiene, 3-(1-methylpropylidene)-cyclohexene, 6-methyl-1-(1-methylethyl)-1,3-cyclohexadiene, 4-methyl-5-(1-methylethenyl)-cyclohexene, o-mentha-4,6-diene, o-mentha-2(8),3-diene, o-mentha-1(7),4-diene, 6-methyl-1-(1-methylethenyl)-cyclohexene, 1-methyl-5-(1-methylethyl)-1,4-cyclohexadiene, isosylvestrene, 4-ethyl-3-ethylidene-cyclohexene, 1-ethyl-6-ethylidene-cyclohexene, o-mentha-3,6-diene, o-mentha-2,5-diene, o-mentha-1,4-diene, 3-methyl-4-isopropenyl-1-cyclohexene, 3-methyl-5-isopropenyl-1-cyclohexene, 2-methyl-3-propyl-1,3-cyclohexadiene, 1-methyl-6-propylidene-cyclohexene, tetranaphtalene and preferably dipentene (formula II).

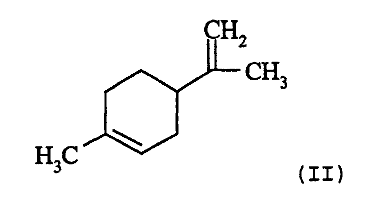

The alcohol used is preferably an aliphatic alcoholether. Suitable examples of such aliphatic alcoholethers are: methoxypropanol, propoxyethanol, 2-butoxyethanol, propanol, 2-(propyloxy)ethanol, fenoxyethanol, benzylalcohol, butoxypropanol, ethoxypropanol, 1-isobutoxy-2-propanol, 1-isomethoxy-2-propanol, 1-propoxy-2-propanol, diacetone alcohol, tetrahydrofurfuryl alcohol, cathechol, trimethylolpropane, ethanediol, propanediol, and butanediol. Highly preferred is 2-butoxyethanol. The alcohol and cyclic compound are preferably present in an amount of 5 to 50 wt.% each and most preferably in an amount of 10 to 30 wt.% each.

The emulsifying agent is preferably an anionic compound and/or comprises an alkylene oxide chain. Suitable examples are Akypo OP80, Akypo RO90 (both commercially available from Chem-Y), Empicol ESC70 (commercially available from Albright & Wilson), Aerosol OT (commercially available from AM Cynamid). The emulsifying agent is preferably present in an amount of 5 to 50 wt.% and most preferably in an amount of 10 to 30 wt.%. The above described alcohol may also function as a co-emulsifying agent.

Furthermore the micro-emulsion can comprise a compound according to formula I: 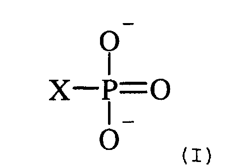 wherein X is OH, O⁻ or a polymer backbone.
The counter ion can be, depending on the pH, H or a metal such as an alkali or alkaline earth metal or a transition metal, e.g. chromium.

Suitable examples of the compound according to formula (I) are polyvinylphosphonic acid, copolymers of vinylphosphonic acid with acrylic acid and vinyl acetate, acrylamidoisobutylene phosphonic acid. Preferably the compound is phosphoric acid or a phosphate salt. The compound is preferably present in an amount of 1.5 to 6 wt.%.

The micro-emulsion obtained as described above can be used in the method according to the present invention for removing ink-accepting areas of a lithographic printing master. The micro-emulsion is capable of removing the ink remaining on the printing areas as well as the hydrophobic coating itself that gives rise to the ink-accepting properties of the printing areas.

The above micro-emulsion is very suitable for removing the ink-accepting areas from a printing master which is obtained by coating a hydrophilic substrate with a coating solution containing hydrophobic thermoplastic polymer particles and a hydrophilic binder. The imaging material thus obtained is negative-working, i.e. hydrophobic areas are formed upon exposure. These areas define the printing areas of the master. It is believed that the applied heat induces a coagulation of the hydrophobic polymer particles, thereby forming a hydrophobic phase, whereas the hydrophobic polymer particles remain unchanged in the non-heated areas. Coagulation may result from heat-induced softening or melting of the thermoplastic polymer particles.

The imaging material which is preferably used in the method of the present invention contains a coating comprising hydrophobic thermoplastic polymer particles having an average particle size between 40nm and 2000nm, and more preferably between 40nm to 200 nm, so as to improve sensitivity and throughput and to avoid scumming. Furthermore the polymer particles preferably have a coagulation temperature above 50°C and more preferably above 70°C. There is no specific upper limit to the coagulation temperature of the polymer particles, however the temperature should be sufficiently below the decomposition temperature of the polymer particles. Preferably the coagulation temperature is at least 10°C below the temperature at which the decomposition of the polymer particles occurs.

Preferred examples of thermoplastic hydrophobic polymer particles for use in the present invention have a Tg above 80°C. The weight average molecular weight of the polymers may range from 5,000 to 5,000,000 g/mol. Preferably the polymer particles are selected from the group consisting of polyvinyl chloride, polyvinylidene chloride, polyesters, polyurethanes, polyacrylonitrile, polyvinyl carbazole etc., and copolymers or mixtures thereof. The most preferred examples are polystyrene and polymethylmethacrylate or copolymers thereof.

The polymer particles are present as a dispersion in the coating solution and may be prepared by the methods disclosed in US 3,476,937. Another method especially suitable for preparing an aqueous dispersion of the thermoplastic polymer particles comprises:
- dissolving the hydrophobic thermoplastic polymer in an organic solvent which does not mix with water,
- dispersing the thus obtained solution in water or in an aqueous medium and
- removing the organic solvent by evaporation.

Suitable hydrophilic binders for use in the present invention are preferably water-soluble (co)polymers for example synthetic homo- or copolymers such as polyvinylalcohol, a poly(meth)acrylic acid, a poly(meth)acrylamide, a polyhydroxyethyl(meth)acrylate, a polyvinylmethylether or natural binders such as gelatine, a polysaccharide such as e.g. dextran, pullulan, cellulose, arabic gum, alginic acid, inuline or chemically modified inuline.

In addition, the coating solution may also contain surfactants that can be anionic, cationic, non-ionic or amphoteric. Perfluoro surfactants are preferred. Particularly preferred are non-ionic perfluoro surfactants. Said surfactants can be used alone or preferably in combination.

The coverage of the coated layer ranges preferably from 0.3 to 20 g/m², more preferably from 0.5 to 5 g/m². The amount of hydrophobic thermoplastic polymer particles contained in the coated layer is preferably between 50 and 90 wt.% and more preferably between 60 and 80 wt.% of the total weight of said layer.

The coating solution is preferably applied to the substrate by spraying or jetting but other coating techniques may also be used.

The substrate used in the present invention can be a plastic support or a ceramic but is preferably a metal such as aluminium. The substrate has a hydrophilic surface and is preferably characterised by a roughness value of at least 0.2 µm, more preferably of at least 0.3 µm, e.g. electrochemically and/or mechanically grained and anodised aluminium. The substrate can be a sheet-like material such as a plate but, alternatively, the coating solution may be applied directly to the plate cylinder of a rotary printing press, said cylinder thereby acting as the substrate. The lithographic substrate can also be a seamless sleeve printing plate, obtained by e.g. soldering a plate into a cylindrical form by means of a laser. The sleeve then can be slid around the plate cylinder instead of mounting a conventional printing plate. More details on sleeves are given in "Grafisch Nieuws" , 15, 1995, page 4 to 6.

The exposure of the imaging material obtained by coating the above coating solution on the lithographic substrate can be carried out by means of direct thermal recording using e.g. a thermal head, or by irradiation with high intensity light. In the latter embodiment, the heat-sensitive material preferably comprises a compound capable of converting light into heat, preferably a compound having sufficient absorption in the wavelength range of the light source used for image-wise exposure. Particularly useful compounds are for example dyes and in particular infrared dyes as disclosed in EP-A 908 307 and pigments and in particular infrared pigments such as carbon black, metal carbides, borides, nitrides, carbonitrides, bronze-structured oxides and oxides structurally related to the bronze family but lacking the A component e.g. WO_{2.9}. It is also possible to use conductive polymer dispersions such as polypyrrole, polyaniline or polythiophene-based conductive polymer dispersions. The lithographic performance and in particular the print endurance obtained depends i.a. on the heat-sensitivity of the imaging material. In this respect it has been found that carbon black yields very good and favourable results.

Image-wise exposure in the method of the present invention is preferably an image-wise scanning exposure involving the use of a laser or L.E.D. Preferably used are lasers that operate in the infrared or near-infrared, i.e. wavelength range of 700-1500 nm. Most preferred are laser diodes emitting in the near infrared.

The printing method of the present invention will be further described hereinafter according to a preferred embodiment. First, a grained and anodised aluminium plate is mounted on the plate cylinder of a rotary printing press. Then, the coating solution described above is sprayed on the hydrophilic lithographic surface of the plate, so as to form a continuous imaging layer. Preferred values of the spraying parameters have been defined in **EP-A 1 084 830** and **EP-A 1 084 862**, both filed on 15th September 1999. The imaging layer is then image-wise exposed by a laser device which is integrated in the printing press e.g. as described in **US-P-5 163 368** and **US-P-5 174 205**, whereby the exposed areas are converted to hydrophobic ink-accepting areas while the unexposed areas remain hydrophilic. The hydrophobic areas define the printing areas of the master. Subsequently, printing is started by applying ink and a fountain solution to the printing master. In order to dissolve and remove the non-exposed areas of the coated layer effectively, only fountain solution is preferably supplied during a few revolutions of the press and then also ink is fed to the plate. After the press run, the lithographic substrate is recycled by treatment with a cleaning liquid as described above. Finally, the substrate can be rinsed with water or an aqueous solution and dried and then, a new printing cycle can be started by spraying the coating solution to the recycled substrate.

The cleaning step can be executed in a cleaning unit similar to the known blanket cleaning system. According to that embodiment, a cloth is preferably moistened with the micro-emulsion, contacted with the printed plate during 1 to 50, more preferably during 2 to 10 revolutions with a contacting pressure between 10 ⁴ and 6x10 ⁵ Pa at a rotation speed in the range of 0.03 to 0.83m/s (2 to 50 m/min). Afterwards the contact between the printing surface and the cleaning cloth is disrupted and the cloth is transported until a dry and clean part of the cloth is available.

The micro-emulsion can also be applied by spraying, coating or jetting the liquid on the lithographic substrate or on the cloth. The removal of the ink-accepting areas can also be effected with another absorbing medium than a cloth. Cleaning can also be effected by combining the treatment with the micro-emulsion of the present invention with other means of mechanical cleaning such as a rotating brush or by jetting water or a volatile medium such as air, a solvent or dry ice pellets. Also vacuum extraction can be used during the cleaning treatment.

All the steps of the method of the present invention are preferably performed on-press. Alternatively, the lithographic substrate can also be mounted on a drum in a dedicated coating apparatus (off-press coating) and subsequently be mounted on a plate setter for image-wise exposure (off-press exposure). Then, the printing master thus obtained can be mounted on a press cylinder and printing is started by supplying ink and a fountain solution. After the press run, the plate can be cleaned as described above, either on-press or in a dedicated cleaning apparatus, and the recycled substrate can then be used again in a next printing cycle.

### Examples

The following examples illustrate the present invention without limiting it thereto. All parts and percentages are by weight unless otherwise specified.

### Example 1: Comparative example

### Preparation of the lithographic base

A 0.30 mm thick aluminium foil was degreased by immersing the foil in an aqueous solution containing 5 g/l of sodium hydroxide at 50°C and rinsed with demineralized water. The foil was then electrochemically grained using an alternating current in an aqueous solution containing 4 g/l of hydrochloric acid, 4 g/l of hydroboric acid and 5 g/l of aluminium ions at a temperature of 35°C and a current density of 1200 A/m² to form a surface topography with an average centre-line roughness Ra of 0.5 µm.

After rinsing with demineralized water the aluminium foil was then etched with an aqueous solution containing 300 g/l of sulphuric acid at 60°C for 180 seconds and rinsed with demineralized water at 25°C for 30 seconds.

The foil was subsequently subjected to anodic oxidation in an aqueous solution containing 200 g/l of sulphuric acid at a temperature of 45°C, a voltage of 10 V and a current density of 150 A/m² for 300 seconds to form an anodic oxidation film of 3.00 g/m² of Al₂O₃ then washed with demineralized water, posttreated with a solution containing polyvinylphosphonic acid and subsequently with a solution containing aluminium trichloride, rinsed with demineralized water at 20°C during 120 seconds and dried.

### Preparation of spray solution

A 2.61 wt.% solution in water was prepared by mixing polystyrene latex, a heat absorbing compound and a hydrophilic binder. After spraying and drying, the resulting layer contained 75 wt.% of the polystyrene latex, 10 wt.% of the heat absorbing compound, presented in formula (I) and 15 wt.% polyacrylic acid (Glascol E15, commercially available at N.V. Allied Colloids Belgium) as hydrophilic binder.

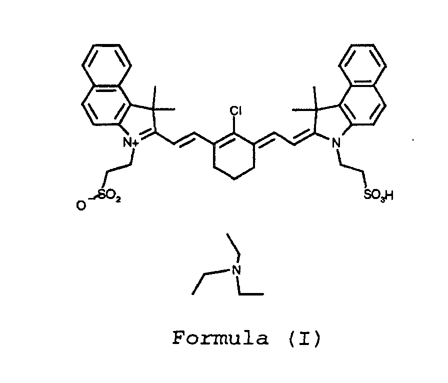

### Preparation of the heat-mode imaging element

The spray solution was sprayed on the above mentioned lithographic base. Therefore, the lithographic base was mounted on a drum, rotating at a line speed of 2.73 m/s (164 m/min). The imaging element was coated by a spray nozzle moving in transverse direction at a speed of 0.025m/s (1.5 m/min). The spray nozzle was mounted on a distance of 80mm between nozzle and receiving substrate. The flow rate of the spray solution was set to 7cm³/min (7 ml/min). During the spray process an air pressure of 620kPa (90 psi) was used on the spray head. This layer was dried on a temperature of 70°C during the spraying process and additionally during 30 s.

The spray nozzle was of the type SUJ1, an air assisted spray nozzle, commercially available from Spraying Systems Belgium, Brussels.

### Printing step

The above mentioned heat mode imaging element was imaged with different screen rulings/renderings in a Creo 3244™ external drum platesetter at 945 dots/cm (2400 dpi) at 2.5 rotations/s (150 rpm) with a power setting of 15.5 Watt. The imaged plates were printed on a GTO46 printing press with K+E 800 Skinnex ink, fountain (Combifix XL from Hostman-Steinberg (4 wt.%) - isopropylalcohol (10 wt.%) in water) to a run length of 5000. The print quality was evaluated.

### Preparation of micro-emulsion A:

10 g of dipentene (commercially available from Sigma-Aldrich) was mixed with 20 g of Akypo OP80 (commercially available from Chem-Y). While stirring, 14 g of butoxyethanol as added. In the next step, 50 g of water was added while stirring.

### Cleaning step:

10 ml/m² of micro-emulsion A was sprayed on the plate which still contained the adhered ink, using a manual pressure sprayer commercially available from Premal Sprayer Division of Precision Valve corporation, New York.

After a time lapse of 30 s during which the micro-emulsion was allowed to interact with the coating, the plate was cleaned by with a standard high pressure washer, using a volume of water of 10 litre/m².

Finally, the plate is dried by pressurised air of room temperature until the plate surface seems dry visually.

### Next cycle

The procedure of spraying, imaging, printing and cleaning was repeated. In the second cycle, the plate was imaged with a full plane of a 50% screen. Afterwards, the plate cleanliness and print characteristics were evaluated.

### Example 2

### Preparation of micro-emulsion B:

10 g of dipentene was mixed with 20 g of Akypo OP80 (commercially available from Chem-Y). While stirring, 14 g of butoxyethanol as added. In the next step, 50 g of water was added. Additionally, 5.9 wt.% of a 85% phosphoric acid solution was added.

The same procedure as mentioned in example 1 was repeated however with micro-emulsion B.

### Example 3

### Preparation of micro-emulsion C:

25 g of dipentene was mixed with 25 g of Akypo OP80 (commercially available from Chem-Y). While stirring, 10 g of butoxyethanol as added. In the next step, 37 g of water was added. Additionally, 3 wt.% of a 85% phosphoric acid solution was added.

The same procedure as mentioned in example 1 was repeated however with micro-emulsion C.

### Example 4

### Preparation of micro-emulsion D:

10 g of dipentene was mixed with 10 g of Aerosol OT (commercially available from AM Cynamid). While stirring, 10 g of butoxyethanol as added. In the next step, 67 g of water was added. Additionally, 3 wt.% of a 85% phosphoric acid solution was added.

The same procedure as mentioned in example 1 was repeated however with micro-emulsion D.

### Example 5

### Preparation of micro-emulsion E:

20 g of dipentene was mixed with 10 g of Aerosol OT (commercially available from AM Cynamid). While stirring, 10 g of butoxyethanol as added. In the next step, 57 g of water was added. Additionally, 3g of a 30 wt.% dispersion of colloidal silica (Syton X30, commercially available at Dupont) in water was added.

The same procedure as mentioned in example 1 was repeated however with micro-emulsion E.

### Thermal stability of cleaner compositions:

The lower and upper cloud point of the above micro-emulsions were determined as the temperature at which the emulsion segregates (gets cloudy) while cooling down or heating a sample in a water bath.

| Micro-emulsion | Lower cloud point (°C) | Upper cloud point (°C) |
|---|---|---|
| A | -2 | 24 |
| B | -1 | 28 |
| C | 14 | 31 |
| D | -1 | 51 |
| E | Nd | Nd |
| Nd. The cloud points of cleaner composition E could not be determined because of the presence of silica (always cloudy). | | |

### Particle size of micro-emulsions:

| cleaner | Particle size 25C Dyn. Light scattering |
|---|---|
| A | Nd. |
| B | 34 |
| C | 16 |
| D | 29 |
| E | 107 |
| Nd. The particle size of cleaner composition A could not be determined (e.g. particle size <10nm, out of the measurement range of the used method). | |

The particle size of the different cleaner compositions was determined with Dynamic light scattering on a Brookhaven BI90 apparatus based on photon correlation spectroscopy .

The above mentioned diameter is the so called effective or PCS diameter based on an cumulant analysis algorithm, a lognormal distribution and is a mean intensity weighted diameter.

### Results of recoat and lithographic quality.

After the first cleaning step mentioned above, the quality of the cleaned plate was determined by visual inspection. For all examples perfectly cleaned materials were obtained and after recoating according to the same method as described above, a very good print quality in respect to staining behaviour and ghost images was observed. Also after multiple cycles of coating, printing and cleaning with the same substrate (up to 20), a good lithographic quality was maintained.

## Claims

1. Method for removing ink-accepting areas of a lithographic printing master wherein a micro-emulsion obtainable by stirring a mixture of a cyclic organic compound containing at least one double bond, an alcohol, water and an emulsifying agent is applied as a cleaning liquid to the printing master.

2. Method according to claim 1 wherein the micro-emulsion is obtained by first mixing a cyclic organic compound having at least one double bond and an emulsifying agent and then adding alcohol and water and stirring.

3. Method according to claims 1 or 2 wherein the cyclic organic compound is dipentene.

4. Method according to any of the preceding claims wherein the alcohol is an aliphatic alcoholether.

5. Method according to claim 4 wherein the aliphatic alcoholether is butoxyethanol.

6. Method according to any of the preceding claims wherein the emulsifying agent is an anionic compound.

7. Method according to any of the preceding claims wherein the emulsifying agent comprises an alkylene-oxide chain.

8. Method according to any of the preceding claims wherein the micro-emulsion further comprises a compound according to formula I: 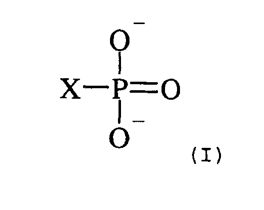 wherein X is OH, O⁻ or a polymer backbone.

9. Direct-to-plate method of lithographic printing with a reusable substrate having a hydrophilic surface comprising the steps of:
(a) making a negative-working imaging material by applying on the hydrophilic surface a coating solution comprising hydrophobic thermoplastic particles and a hydrophilic binder;
(b) making a printing master having ink-accepting areas by image-wise exposing the imaging material;
(c) applying ink and fountain solution to the printing master;
(d) removing the ink-accepting areas from the printing master by a method according to claim 1.

10. Method according to any of the preceding claims wherein during the cleaning step the printing master is treated by mechanical means such as a cloth, a rotating brush or by jetting water or a volatile medium.

11. Method according to claims 9 or 10 wherein the reusable substrate is a plate cylinder of a rotary press or a plate or sleeve mounted on a plate cylinder of a rotary press.

12. Method according to any of the preceding claims wherein the coating solution and the cleaning liquid are sprayed and/or jetted onto the printing master.

## Patentansprüche

1. Verfahren zur Entfernung von farbanziehenden Bereichen eines lithografischen Druckmasters, wobei eine Mikroemulsion, die durch Rühren eines Gemisches aus einer cyclischen organischen Verbindung, die zumindest eine Doppelbindung enthält, einem Alkohol, Wasser und einem Emulgierungsmittel angefertigt wird, als Reinigungsflüssigkeit auf den Druckmaster angebracht wird.

2. Verfahren nach Anspruch 1, **dadurch gekennzeichnet, daß** die Mikroemulsion angefertigt wird, indem zunächst eine cyclische organische, zumindest eine Doppelbindung enthaltende Verbindung und ein Emulgierungsmittel versetzt und anschließend Wasser und Alkohol zugegeben werden und dann gerührt wird.

3. Verfahren nach Anspruch 1 oder 2, **dadurch gekennzeichnet, daß** die cyclische organische Verbindung Dipenten ist.

4. Verfahren nach einem der vorstehenden Ansprüche, **dadurch gekennzeichnet, daß** der Alkohol ein alifatischer Alkoholether ist.

5. Verfahren nach Anspruch 4, **dadurch gekennzeichnet, daß** der alifatische Alkoholether Butoxyethanol ist.

6. Verfahren nach einem der vorstehenden Ansprüche, **dadurch gekennzeichnet, daß** das Emulgierungsmittel eine anionische Verbindung ist.

7. Verfahren nach einem der vorstehenden Ansprüche, **dadurch gekennzeichnet, daß** das Emulgierungsmittel eine Alkylenoxidkette enthält.

8. Verfahren nach einem der vorstehenden Ansprüche, **dadurch gekennzeichnet, daß** die Mikroemulsion weiterhin eine Verbindung der Formel I enthält : 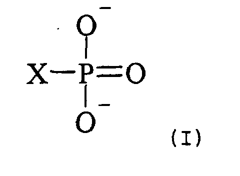 in der X OH, O⁻ oder eine Polymerhauptkette bedeutet.

9. Ein durch die folgenden Schritte gekennzeichnetes lithografisches Direct-to-Plate-Druckverfahren mit einem wiederverwertbaren Substrat mit einer hydrophilen Oberfläche :
(a) Herstellung eines negativarbeitenden Bilderzeugungsmaterials durch Auftrag einer hydrophobe thermoplastische Teilchen und ein hydrophiles Bindemittel enthaltenden Gießlösung auf die hydrophile Oberfläche,
(b) Herstellung eines Druckmasters mit farbanziehenden Bereichen durch bildmäßige Belichtung des Bilderzeugungsmaterials,
(c) Auftrag von Druckfarbe und Feuchtwasser auf den Druckmaster,
(d) Entfernung der farbanziehenden Bereiche vom Druckmaster nach einem in Anspruch 1 definierten Verfahren.

10. Verfahren nach einem der vorstehenden Ansprüche, **dadurch gekennzeichnet, daß** der Druckmaster während des Reinigungsschrittes mit Hilfe von mechanischen Mitteln wie einem Tuch, einer Drehbürste oder durch Aufspritzen von Wasser oder eines flüchtigen Mediums behandelt wird.

11. Verfahren nach Anspruch 9 oder 10, **dadurch gekennzeichnet, daß** das wiederverwertbare Substrat ein Plattenzylinder einer Rotationsdruckpresse oder eine auf einen Plattenzylinder einer Rotationsdruckpresse aufgespannte Platte oder hülsenförmige Platte ist.

12. Verfahren nach einem der vorstehenden Ansprüche, **dadurch gekennzeichnet, daß** die Gießlösung und die Reinigungsflüssigkeit auf den Druckmaster aufgesprüht und/oder aufgeschleudert werden.

## Revendications

1. Procédé pour éliminer des zones amoureuses de l'encre d'une matrice d'impression lithographique, dans lequel on applique une microémulsion que l'on obtient par agitation d'un mélange d'un composé organique cyclique contenant au moins une liaison double, un alcool, de l'eau et un agent d'émulsification, à titre de liquide de nettoyage sur la matrice d'impression.

2. Procédé selon la revendication 1, dans lequel on obtient la microémulsion en mélangeant d'abord un composé organique cyclique possédant au moins une liaison double et un agent d'émulsification avant d'ajouter de l'alcool et de l'eau et avant d'agiter.

3. Procédé selon la revendication 1 ou 2, dans lequel le composé organique cyclique est le dipentène.

4. Procédé selon l'une quelconque des revendications précédentes, dans lequel l'alcool est un étheralcool aliphatique.

5. Procédé selon la revendication 4, dans lequel l'étheralcool aliphatique est le butoxyéthanol.

6. Procédé selon l'une quelconque des revendications précédentes, dans lequel l'agent d'émulsification est un composé anionique.

7. Procédé selon l'une quelconque des revendications précédentes, dans lequel l'agent d'émulsification comprend une chaîne d'oxyde d'alkylène.

8. Procédé selon l'une quelconque des revendications précédentes, dans lequel la microémulsion comprend en outre un composé répondant à la formule I : 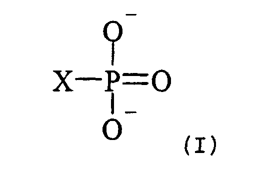 dans laquelle X représente OH, O⁻ ou un squelette polymère.

9. Procédé d'impression lithographique faisant appel à une imageuse de plaques flexographiques (= procédé "direct-to-plate") comprenant un substrat réutilisable possédant une surface hydrophile, comprenant les étapes consistant à :
(a) préparer un matériau de formation d'image à traitement négatif en appliquant sur la surface hydrophile une solution d'enduction comprenant des particules thermoplastiques hydrophobes et un liant hydrophile ;
(b) préparer une matrice d'impression possédant des zones amoureuses de l'encre par exposition du matériau de formation d'image en forme d'image ;
(c) appliquer de l'encre et une solution de mouillage sur la matrice d'impression ;
(d) éliminer des zones amoureuses de l'encre de la matrice d'impression via un procédé selon la revendication 1.

10. Procédé selon l'une quelconque des revendications précédentes, dans lequel, au cours de l'étape de nettoyage, la matrice d'impression est traitée à l'aide d'un moyen mécanique tel qu'un chiffon, une brosse rotative ou encore en projetant de l'eau ou un milieu volatil.

11. Procédé selon l'une quelconque des revendications 9 ou 10, dans lequel le substrat réutilisable est un cylindre porte-plaque d'une presse rotative ou encore une plaque ou un manchon monté sur un cylindre porte-plaque d'une presse rotative.

12. Procédé selon l'une quelconque des revendications précédentes, dans lequel on pulvérise et/ou on projette la solution d'enduction et le liquide de nettoyage sur la matrice d'impression.
